# EUROPEAN PATENT APPLICATION

(11) **EP 4 832 679 A1**
(43) Date of publication of application: **28.10.2026**
(21) Application number: 24918292.4
(22) Date of filing: 17.12.2024
(51) Int. Cl.: H05K 7/20

(54) **HEAT SINK AND ELECTRONIC DEVICE**

(30) Priority: 19.01.2024 CN 202410084741
(71) Applicant: ZTE CORPORATION, Shenzhen, Guangdong 518057 (CN)
(72) Inventor: TAN, Zhoutuo, Shenzhen, Guangdong 518057 (CN); SUN, Zhen, Shenzhen, Guangdong 518057 (CN); BAI, Hongwei, Shenzhen, Guangdong 518057 (CN); LIU, Fan, Shenzhen, Guangdong 518057 (CN); XU, Qingsong, Shenzhen, Guangdong 518057 (CN)
(74) Representative: Ziebig Hengelhaupt Intellectual Property Attorneys Patentanwaltskanzlei PartGmbB
(86) International application number: PCT/CN2024/139984
(87) International publication number: WO 2025/152684

(57) **Abstract**

The present application discloses a heat sink and an electronic device. The heat sink comprises a heat dissipation base (10) and first heat pipes (20). The heat dissipation base (10) is provided with evaporation chambers (11); a first phase-change medium is disposed in the evaporation chambers (11); two ends of each of the first heat pipes (20) are both closed ends; a second phase-change medium is disposed in pipe cavities (21) of the first heat pipes (20); evaporation ends (22) of the first heat pipes (20) are connected to a heat dissipation surface (12) of the heat dissipation base (10), and condensation ends (23) of the first heat pipes (20) extend beyond the edge of the heat dissipation surface (12) and extend away from the heat dissipation base (10); and the pipe cavities (21) of the first heat pipes (20) are isolated from the evaporation chambers (11).

## Description

### CROSS-REFERENCE TO RELATED APPLICATIONS

The present application claims the priority of the Chinese patent application No. 202410084741.6 filed with the CNIPA on January 19, 2024, and entitled "HEAT SINK AND ELECTRONIC DEVICE", of which the entire contents are incorporated herein by reference.

### TECHNICAL FIELD

The present application belongs to the technical field of heat sinks, and specifically relates to a heat sink and an electronic device.

### BACKGROUND

Servers are core electronic devices for the development of big data and communication technologies. As computing capabilities of the servers are continuously improved, power consumption and heat flux density of the servers are also increasing year by year. This places higher demands for heat sinks used in conjunction with the servers. However, heat sinks in related art still suffer from poor heat dissipation. Certainly, other devices, not limited to the servers, that generate high levels of heat during operation also need to be equipped with the heat sinks, and these heat sinks similarly have the problem of poor heat dissipation effect.

### SUMMARY

The present application discloses a heat sink and an electronic device, aiming to solve the problem of poor heat dissipation effect of the heat sink in the related art.

In a first aspect, an embodiment of the present application discloses a heat sink. The disclosed heat sink includes a heat dissipation base and a first heat pipe. The heat dissipation base is provided with an evaporation cavity, a first phase-change medium is disposed in the evaporation cavity, two ends of the first heat pipe are both closed ends, a second phase-change medium is disposed in a pipe cavity of the first heat pipe, an evaporation end of the first heat pipe is connected to a heat dissipation surface of the heat dissipation base, a condensation end of the first heat pipe extends beyond an edge of the heat dissipation surface and extends in a direction away from the heat dissipation base, and the pipe cavity of the first heat pipe is isolated from the evaporation cavity.

In a second aspect, an embodiment of the present application discloses an electronic device. The disclosed electronic device includes the heat sink described in the above embodiment.

### BRIEF DESCRIPTION OF DRAWING(S)

FIG. 1 is a schematic stereoscopic structural diagram of a heat sink disclosed in an embodiment of the present application.
FIG. 2 is a schematic stereoscopic structural diagram of a partial structure of a heat sink disclosed in an embodiment of the present application, wherein in FIG. 2, a shell portion 14 and a cover body 15 are in an unassembled state.
FIG. 3 is a sectional view of a partial structure of a heat sink disclosed in an embodiment of the present application, wherein hollow arrows in FIG. 3 indicate a heat flow direction of heat generated by an object subjected to heat dissipation flowing to a heat dissipation base, solid arrows in FIG. 3 indicate a liquid flowing direction of a corresponding phase-change medium when it is in a liquid state, and dashed arrows in FIG. 3 indicate a vapor flowing direction of the corresponding phase-change medium when it is in a gaseous state.
FIG. 4 and FIG. 5 are schematic diagrams of partial structures of two different heat sinks respectively.

### Description of reference numerals:

10-Heat dissipation base; 11-Evaporation cavity; 12-Heat dissipation surface; 13-Third capillary structure; 14-Shell portion; 15-Cover body; 20-First heat pipe; 21- Pipe cavity; 22-Evaporation end; 23-Condensation end; 24-First capillary structure; 30-First heat dissipation fin; 40-First enclosing plate; 50-Connection base plate; 60-Second heat pipe; 61-Evaporation end; 62-Pipe cavity; 63-Condensation end; 64-Second capillary structure; 70-Second heat dissipation fin; 80-Second enclosing plate; 01-First heat dissipation structure; 011-Sub-heat-dissipation structure; 02-Second heat dissipation structure; and 03-Object subjected to heat dissipation.

### DETAILED DESCRIPTION

In order to make objectives, technical solutions and advantages of the present application clearer, the technical solutions of the present application will be described below clearly and completely with reference to specific embodiments of the present application and corresponding accompanying drawings. Apparently, the described embodiments are only part of the embodiments of the present application, not all of the embodiments. All other embodiments obtained by those ordinarily skilled in the art based on the embodiments in the present application without creative efforts shall fall within the scope of protection of the present application.

The technical solutions disclosed by the embodiments of the present application are described in detail below with reference to the accompanying drawings.

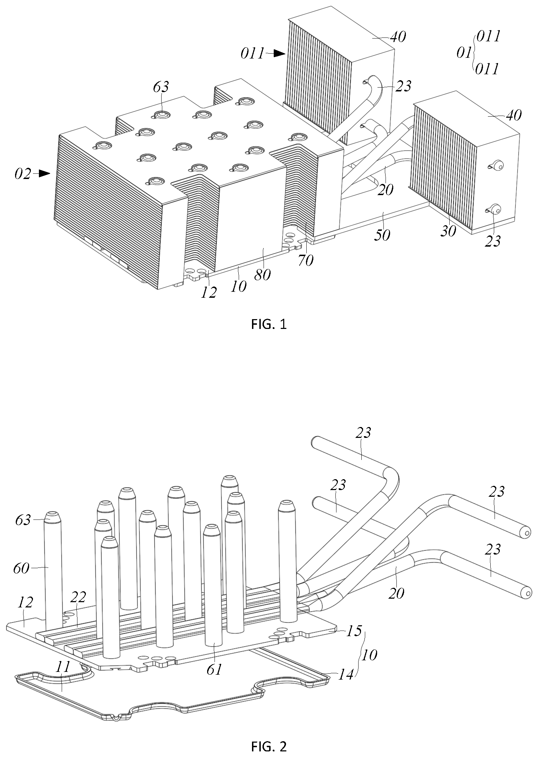

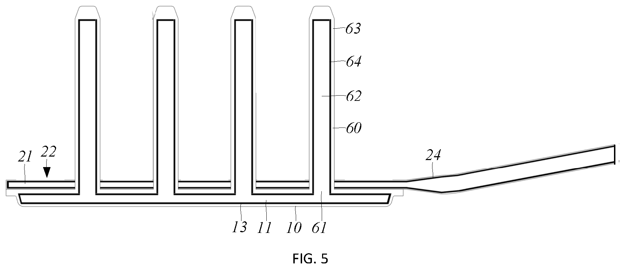

Referring to FIG. 1 to FIG. 5, an embodiment of the present application discloses a heat sink. The disclosed heat sink is configured to dissipate heat from an object 03 subjected to heat dissipation. The object 03 subjected to heat dissipation may be a server, a chip, or the like. The embodiment of the present application does not limit the type of the object 03 subjected to heat dissipation. The disclosed heat sink may include a heat dissipation base 10 and first heat pipes 20.

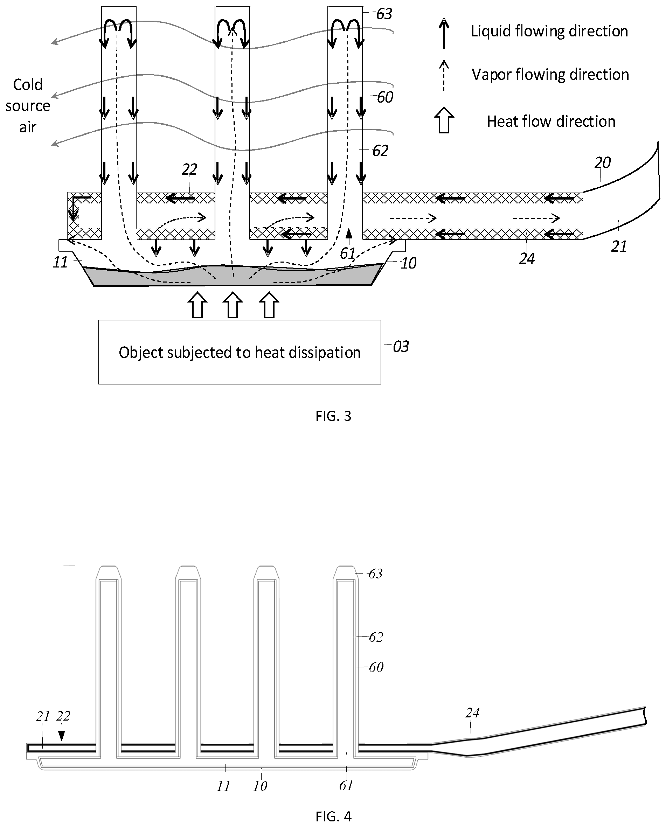

The heat dissipation base 10 is a base part of the heat sink. The heat dissipation base 10 may be in contact with the object 03 subjected to heat dissipation, so that heat generated by the object 03 subjected to heat dissipation (for example, in a direction indicated by the hollow arrows in FIG. 3) is transferred to the heat dissipation base 10, and then to the heat sink for dissipation. The heat dissipation base 10 is provided with an evaporation cavity 11, and a first phase-change medium is disposed in the evaporation cavity 11. The heat generated by the object 03 subjected to heat dissipation is transferred into the evaporation cavity 11, so as to heat the first phase-change medium, thereby causing the first phase-change medium to be evaporated into a gaseous state and absorb heat. The gaseous first phase-change medium may be cooled and condensed in a region away from the object subjected to heat dissipation, thereby releasing the heat and ultimately achieving heat dissipation. Certainly, the first phase-change medium condensed into the liquid state flows back, and then is heated and evaporated, thereby entering the next heat dissipation cycle. In the embodiment of the present application, the heat dissipation base 10 has a heat dissipation surface 12. The heat dissipation surface 12 may be a planar surface or non-planar surface, such as a curved surface. The embodiment of the present application does not limit a shape of the heat dissipation surface 12.

In the embodiment of the present application, the heat dissipation base 10 may be of various structures. For example, the heat dissipation base 10 may be of a plate-like structure or a non-plate-like structure. In one implementation, the heat dissipation base 10 may be a vapor chamber. The vapor chamber is a heat dissipation component with good heat dissipation performance, which helps improve the heat dissipation performance of the overall heat sink. In the embodiment of the present application, the heat dissipation base 10 may be of a split structure or an integral structure. To facilitate the formation of the evaporation cavity 11, in one implementation, the heat dissipation base 10 may include a shell portion 14 and a cover body 15. The cover body 15 may be detachably fixed at an opening of the shell portion 14 and together with the shell portion 14 encloses the evaporation cavity 11, as shown in FIG. 2.

In an exemplary embodiment, the heat dissipation base 10 may be fixed onto the object 03 subjected to heat dissipation, thereby achieving assembly of the heat sink with the object 03 subjected to heat dissipation. This solution can ensure a relatively stable heat transfer cooperation between the heat dissipation base 10 and the object 03 subjected to heat dissipation.

Two ends of each of the first heat pipes 20 are closed ends. A second phase-change medium is disposed in a pipe cavity 21 of each first heat pipe 20. Since the two ends of each of the first heat pipes 20 are the closed ends, the second phase-change medium is confined within the pipe cavities 21 of the first heat pipes 20. Evaporation ends 22 of the first heat pipes 20 are connected to the heat dissipation surface 12 of the heat dissipation base 10. Condensation ends 23 of the first heat pipes 20 extend in a direction away from the heat dissipation base 10. The pipe cavities 21 of the first heat pipes 20 are isolated from the evaporation cavity 11 of the heat dissipation base 10, so that the first phase-change medium and the second phase-change medium do not mix with each other. In the embodiment of the present application, the first phase-change medium and the second phase-change medium each dissipate heat through an evaporation-condensation cycle. In a case of exerting a heat dissipation function, the heat dissipation surface 12 can also transfer heat to the first heat pipes 20 through its cooperation with the evaporation ends 22 of the first heat pipes 20, so that the heat is then dissipated by the first heat pipes 20. This can improve the efficiency of the condensation-liquid return-re-evaporation cycle on the heat dissipation surface 12, and help to increase a critical heat flux density of the heat sink, thereby enhancing the heat dissipation capacity of the heat sink.

To ensure the structural stability of the heat sink, the first heat pipes 20 and the heat dissipation base 10 may be fixedly connected in manners such as welding, bonding, connecting via connectors, and snap-fitting. Such connection manner can ensure that the evaporation ends 22 of the first heat pipes 20 are in relatively stable contact with the heat dissipation surface 12, which is conducive to receiving heat dissipated from the heat dissipation base 10 and subsequently dissipating the heat. The first heat pipes 20 and the heat dissipation base 10 may be connected in a non-detachable manner or in a detachable manner. To facilitate flexible inspection and replacement of individual components, in an exemplary embodiment, the first heat pipes 20 may be detachably connected to the heat dissipation base 10. For example, the first heat pipes 20 and the heat dissipation base 10 are detachably connected in manners such as connecting via connectors (e.g., threaded connectors), and snap-fitting. It should be noted that the embodiment of the present application does not limit the connection manner between the first heat pipes 20 and the heat dissipation base 10.

In an exemplary embodiment, the condensation ends 23 of the first heat pipes 20 may extend beyond an edge of the heat dissipation surface 12. In other words, the condensation ends 23 of the first heat pipes 20 are not located within a space toward which the heat dissipation surface 12 faces. Such structure enables that the condensation ends 23 of the first heat pipes 20 are not subjected to condensation and heat dissipation within the space toward which the heat dissipation surface 12 of the heat dissipation base 10 faces, and thus the heat needing to be dissipated can be better transported to a more distant location, thereby achieving a good heat dissipation effect and better avoiding adverse effects on the heat dissipation of the heat dissipation base 10 due to the fact that the heat is close to the heat dissipation base 10.

According to the heat sink disclosed in the embodiment of the present application, through structural design, the heat dissipation base 10 and the first heat pipes 20 cooperate with each other to dissipate the heat. Meanwhile, the first heat pipes 20 can transport the heat obtained from the heat dissipation base 10 to the condensation ends 23 of the first heat pipes 20 for dissipation at a location away from the heat dissipation surface 12. In this process, the first heat pipes 20 can transport the heat to a location farther from the heat dissipation base 10 for dissipation, thereby ensuring that the first heat pipes 20 exert the independent heat dissipation function while also preventing the first heat pipes 20 from adversely affecting the heat dissipation of the heat dissipation base 10. Consequently, the heat dissipation performance of the overall heat sink can be greatly improved.

In addition, the pipe cavities 21 of the first heat pipes 20 and the evaporation cavity 11 of the heat dissipation base 10 are isolated from each other and thus do no need communicate with each other, thereby avoiding the problem of a cumbersome operation resulting from making the pipe cavities 21 of the first heat pipes 20 communicate with the evaporation cavity 11 of the heat dissipation base 10. Since the evaporation cavity 11 and the pipe cavities 21 of the first heat pipes 20 are isolated from each other, the heat dissipation base 10 and the first heat pipes 20 may be independently manufactured and then connected. Product manufacturers can more easily continue to use relatively simple or existing production lines for manufacturing, which is higher in process maturity, is higher in yield, and is also conducive to controlling manufacturing costs. During assembly, it is only necessary to connect the evaporation ends 22 of the first heat pipes 20 to the heat dissipation surface 12 of the heat dissipation base 10. No further communication is required, nor is there a need to consider a sealing problem possibly resulting from such communication, which also helps increase the yield of the heat sink.

Certainly, in a case where first capillary structures 24 are disposed in the pipe cavities 21 of the first heat pipes 20 and a third capillary structure 13 is disposed in the evaporation cavity 11 of the heat dissipation base 10, if the pipe cavities 21 of the first heat pipes 20 communicate with the evaporation cavity 11 of the heat dissipation base 10, an effective lap joint between the first capillary structures 24 and the third capillary structure 13 is further required. The lap joint between the first capillary structures 24 and the third capillary structure 13 is a delicate operation that is not easily accomplished, which is in turn prone to leading to a low yield of the heat sink. However, in the embodiment of the present application, since the evaporation cavity 11 of the heat dissipation base 10 and the pipe cavities 21 of the first heat pipes 20 are isolated from each other and do not need communicate with each other, there is no need to perform lap joint on the first capillary structures 24 in the first heat pipes 20 and the third capillary structure 13 in the heat dissipation base 10. This eliminates the cumbersome and difficult-to-succeed assembly operations between the first heat pipes 20 and the heat dissipation base 10, thereby facilitating the manufacturing of the heat sink and ensuring the yield of the heat sink.

To increase a heat contact area, in an exemplary embodiment, the evaporation ends 22 of the first heat pipes 20 may be flattened structure ends. The flattened structure ends may be connected to the heat dissipation surface 12 in a manner of surface-to-surface attachment. Such structure makes the first heat pipes 20 to contact with the heat dissipation surface 12 over a larger area, which facilitates better reception of heat dissipated from the heat dissipation surface 12, and further facilitates transferring this part of heat to the more distant condensation ends 23 for dissipation.

A flat structure end and the heat dissipation surface 12 may be connected through surface-to-surface attachment formed between non-planar surfaces, or through surface-to-surface attachment formed between planar surfaces, which is not limited in the embodiment of the present application. Considering that a relatively regular surface is conducive to assembly and also helps improve the product appearance, in an exemplary embodiment, the heat dissipation base 10 may be a vapor chamber, and the heat dissipation surface 12 may be a planar surface. Accordingly, the evaporation ends 22 of the first heat pipes 20 may be flat structure ends. The flat structure ends may be connected to the heat dissipation surface 12 through a surface-to-surface attachment structure formed between planar surfaces.

To further enhance the heat dissipation capability, in an exemplary embodiment, the heat sink disclosed in the embodiment of the present application may further include a first heat dissipation structure 01. The condensation ends 23 of the first heat pipes 20 may be connected in the first heat dissipation structure 01, and the first heat dissipation structure 01 may be provided with a first air passage penetrating therethrough in a first preset direction. In this case, the heat dissipated from the condensation ends 23 of the first heat pipes 20 can be better dissipated by the first heat dissipation structure 01. The addition of the first heat dissipation structure 01 can increase the heat dissipation area at the condensation ends 23 of the first heat pipes 20, thereby reducing the thermal resistance of the overall heat sink. This allows the condensation ends 23 of the first heat pipes 20 connected to the first heat dissipation structure to dissipate the heat more efficiently, which in turn helps improve the heat dissipation efficiency. At the same time, the first air passage can guide cool air to flow in the first preset direction, thereby preventing the cool air from dispersing in all directions, prolonging the contact time between the cool air and the first heat dissipation structure 01, and ultimately further helping to improve the heat dissipation effect.

In the embodiment of the present application, the first heat dissipation structure 01 may be of various structures. For example, the first heat dissipation structure 01 may be a first air-guiding heat dissipation pipe, and the condensation ends 23 of the first heat pipes 20 may extend into the first air-guiding heat dissipation pipe. In this case, a pipe cavity of the first heat-guiding heat dissipation pipe can be considered as the first air passage.

Certainly, the first heat dissipation structure 01 may also be of other structures. In an exemplary embodiment, the first heat dissipation structure 01 may include a first heat dissipation fin 30 and a first enclosing plate 40. The first enclosing plate 40 is disposed around the first heat dissipation fin 30, thereby enclosing the first air passage together with the first heat dissipation fin 30. There may be one or more first heat dissipation fins 30. The embodiment of the present application does not limit the number of the first heat dissipation fins 30. In a case where there is one first heat dissipation fin 30, the first enclosing plate 40 encloses the first heat dissipation fin 30, thereby enclosing the first air passage together with the first heat dissipation fin 30. In a case where there are the plurality of first heat dissipation fins 30, the plurality of first heat dissipation fins 30 are distributed in a stacked manner, and the two adjacent first heat dissipation fins 30 are distributed at intervals, so as to form a first heat dissipation gap. The first enclosing plate 40 encloses a circumferential side of a whole formed by stacking the plurality of first heat dissipation fins 30, so that the first heat dissipation gap between the two adjacent first heat dissipation fins 30 is enclosed to form the first air passage.

The first heat dissipation structure 01 may at least include the first heat dissipation fins 30. To further increase the heat dissipation area, the first heat dissipation structure 01 may further include heat dissipation protrusions disposed on the surfaces of the first heat dissipation fins 30. The heat dissipation protrusions may be strip-shaped protrusions or pin-shaped protrusions, which is not limited in the embodiment of the present application.

In the embodiment of the present application, there may be one or more first heat pipes 20. To improve the heat dissipation capability, in an exemplary embodiment, there may be the plurality of first heat pipes 20. In one implementation, the evaporation ends 22 of the plurality of first heat pipes 20 are connected to the heat dissipation surface 12 at intervals, thereby reducing mutual interference in heat dissipation. Any two first heat pipes 20 are distributed at intervals.

In a case where there are the plurality of first heat pipes 20, the first heat pipes 20 may be ungrouped, and accordingly, the first heat dissipation structure 01 may also be ungrouped. In other embodiments, the first heat pipes 20 may be grouped, and accordingly, the first heat dissipation structure 01 may also be grouped.

In an exemplary embodiment, in a case where the heat sink includes the first heat dissipation structure 01 and there are the plurality of first heat pipes 20, any two first heat pipes 20 are distributed at intervals. The plurality of first heat pipes 20 may be distributed in at least two groups, with each group including at least one first heat pipe 20. The first heat dissipation structure 01 may include a plurality of sub-heat-dissipation structures 011. The condensation ends 23 of each group of first heat pipes 20 may be connected in the corresponding sub-heat-dissipation structure 011. Each sub-heat-dissipation structure 011 may be provided with a first air passage penetrating therethrough in the first preset direction.

In an exemplary embodiment, each of the sub-heat-dissipation structures 011 may include the plurality of first heat dissipation fins 30 and the first enclosing plate 40. In each sub-heat-dissipation structure 011, the plurality of first heat dissipation fins 30 are distributed in a stacked manner, and the first enclosing plate 40 may enclose a circumferential side of a whole formed by stacking the plurality of first heat dissipation fins 30, so that the first heat dissipation gap between the two adjacent first heat dissipation fins 30 is enclosed to form the first air passage. In this case, the plurality of first heat pipes 20 are distributed in groups, and the first heat dissipation structure 01 can configure the corresponding sub-heat-dissipation structure 011 for each group of first heat pipes 20, so as to prevent all the first heat pipes 20 from converging at one location. This can make each group of first heat pipes 20 to enhance the heat dissipation effect through the corresponding sub-heat-dissipation structure 011, which undoubtedly further improves the heat dissipation capability of the overall heat sink.

The first air passage allows air to flow from one end of the first air passage to the other end, thereby enabling continuous and good heat exchange with the first heat dissipation fins 30. In essence, in this structure, the first enclosing plate 40 can enclose part of an edge of a first air passage gap, thereby preventing the problem of insufficient heat exchange caused by air dispersing in all directions, which indirectly enhances the heat dissipation capability of the heat sink. In addition, the first enclosing plate 40 can also make the strength of the first heat dissipation structure 01 higher, achieving an effect of dual purposes with a single component.

The heat sink disclosed in the embodiment of the present application may further include a connection base plate 50, the connection base plate 50 is fixedly connected to the heat dissipation base 10, and the first heat dissipation structure 01 is supported on the connection base plate 50. In such structure, the connection base plate 50 is similar to a base connected to the heat dissipation base 10, so as to form an integral base body together with the heat dissipation base 10, thereby providing support for the first heat dissipation structure 01, and in turn helping improve the overall structural stability of the heat sink. At the same time, the connection base plate 50 also has a reinforcing function, helping to improve the overall strength of the heat sink.

In particular, in a case where the first heat dissipation structure 01 includes the plurality of sub-heat-dissipation structures 011, the plurality of sub-heat-dissipation structures 011 are all supported on the connection base plate 50, which helps improve the structural stability of the plurality of sub-heat-dissipation structures 011. The first heat dissipation structure 01 may be fixed onto the connection base plate 50. For example, the first heat dissipation fins 30 may be fixedly connected to the connection base plate 50 in manners such as welding, bonding, or connecting via connectors, thereby achieving a fixed connection between the first heat dissipation structure 01 and the connection base plate 50. This can further improve the overall strength of the heat sink.

In one implementation, a first end of the connection base plate 50 may be fixed to the heat dissipation surface 12, and a second end of the connection base plate 50 may be fixed to the first heat dissipation structure 01 and support the first heat dissipation structure 01. Such structure also helps ensure the local strength of the heat sink, such as the condensation ends 23 of the first heat pipes 20 and the first heat dissipation structure 01.

During heat dissipation, the second phase-change medium in the first heat pipes 20 evaporates into a gaseous state at the evaporation ends 22 and then moves to the condensation ends 23 of the first heat pipes 20 to achieve condensation. The second phase-change medium, after condensing into a liquid state, flows back toward the evaporation ends 22 of the first heat pipes 20. To facilitate the backflow of the liquid second phase-change medium, in an exemplary embodiment, the condensation ends 23 of the first heat pipes 20 may be higher than the evaporation ends 22 of the first heat pipes 20.

Considering that the condensation ends 23 of the first heat pipes 20 may extend to a distant location, in the embodiment of the present application, the first capillary structures 24 may be disposed in the first heat pipes 20. The first capillary structures 24 facilitate rapid backflow of the liquid second phase-change medium. The second phase-change medium may be water or other solutions, such as a refrigerant. The embodiment of the present application does not limit the type of the second phase-change medium. In a case where the second phase-change medium is water, disposing the first capillary structures 24 in the first heat pipes 20 can prevent the water from freezing, thereby avoiding damage to the first heat pipes 20 caused by ice swelling due to localized water freezing. Certainly, in a case where the second phase-change medium is water, a third capillary structure 13 may be disposed in the evaporation cavity 11 of the heat dissipation base 10, thereby avoiding damage to the heat dissipation base 10 caused by ice swelling due to localized water freezing. Certainly, the second phase-change medium may be a phase-change medium having a freezing point lower than an ice point, such as a refrigerant. In this case, the second phase-change medium is not prone to freezing, and the first capillary structures 24 may not be disposed in the first heat pipes 20. Similarly, the third capillary structure 13 may also not be disposed in the heat dissipation base 10.

To improve the heat dissipation performance of the heat sink, the heat sink disclosed in the embodiment of the present application may further include second heat pipes 60. Evaporation ends 61 of the second heat pipes 60 are open ends and make pipe cavities 62 of the second heat pipes 60 communicate with the evaporation cavity 11. Condensation ends 63 of the second heat pipes 60 extend in a direction away from the heat dissipation surface 12. The second heat pipes 60 may be located within a space enclosed by an edge of the heat dissipation surface 12. In this case, the second heat pipes 60 also exert a heat dissipation function, and can dissipate the heat within the space enclosed by the edge of the heat dissipation surface 12. At the same time, the first heat pipes 20 and the second heat pipes 60 can make full use of the heat dissipation surface 12 to be connected with the heat dissipation base 10, which helps improve the heat dissipation efficiency.

In the heat sink disclosed in the embodiment of the present application, the heat dissipation base 10 may have an independent evaporation cavity 11 and condensation cavity, thereby independently achieving the heat dissipation function through the first phase-change medium. In the embodiment where the heat sink includes the second heat pipes 60 and the pipe cavities 62 of the second heat pipes 60 communicate with the evaporation cavity 11 of the heat dissipation base 10, the evaporation cavity 11 of the heat dissipation base 10 serves as an evaporation region of a 3DVC heat sink formed by the heat dissipation base 10 and the second heat pipes 60, and the condensation ends 63 of the second heat pipes 60 serve as a condensation region of the 3DVC heat sink formed by the heat dissipation base 10 and the second heat pipes 60, thereby forming a more multi-dimensional three-dimensional heat dissipation structure, which can improve the heat dissipation capability of the heat sink.

The second heat pipes 60 may be perpendicular to the heat dissipation surface 12. Certainly, the second heat pipes 60 may also form an acute angle with the heat dissipation surface 12. The embodiment of the present application does not limit an included angle between the second heat pipes 60 and the heat dissipation surface 12.

There may be one or more second heat pipes 60. To further improve the heat dissipation capability of the heat sink, in an exemplary embodiment, there may be the plurality of second heat pipes 60, and the plurality of second heat pipes 60 may be distributed on the heat dissipation surface 12 in a preset manner. The plurality of second heat pipes 60 may be distributed in rows and columns on the heat dissipation surface 12. Alternatively, the plurality of second heat pipes 60 may be evenly distributed within a circular region. Certainly, the embodiment of the present application does not limit the distribution manner of the plurality of second heat pipes 60 on the heat dissipation surface 12.

To make the backflow of the first phase-change medium easier, second capillary structures 64 may be disposed in the second heat pipes 60, a third capillary structure 13 may be disposed in the evaporation cavity 11, and the second capillary structures 64 are connected to the third capillary structure 13 to form a liquid guiding structure. As described above, the second heat pipes 60 and the heat dissipation base 10 form the 3DVC heat sink. The condensation ends 63 of the second heat pipes 60 serve as the condensation region of the 3DVC heat sink, and the evaporation cavity 11 of the heat dissipation base 10 serves as the evaporation region of the 3DVC heat sink. During the process of heat dissipation, the first phase-change medium evaporates into a gaseous state within the evaporation cavity 11, and the gaseous first phase-change medium enters the condensation region (where it exchanges heat with cold source air, as shown in FIG. 3) and is condensed in the condensation region to release the heat. After condensing into the liquid state in the condensation region, the first phase-change medium is guided by the liquid guiding structure to quickly return to the evaporation cavity 11, thereby preparing for the next evaporation cycle. The liquid guiding structure formed by the second capillary structures 64 and the third capillary structure 13 can increase the backflow rate of the liquid first phase-change medium, thereby improving the heat dissipation cycle efficiency and achieving the purpose of enhancing the heat dissipation capability of the heat sink.

To further improve the heat dissipation capability of the heat sink, the heat sink disclosed in the embodiment of the present application may further include a second heat dissipation structure 02. The condensation ends 63 of the second heat pipes 60 may be connected in the second heat dissipation structure 02. The second heat dissipation structure 02 is provided with a second air passage penetrating therethrough in a second preset direction. In this case, the heat dissipated from the condensation ends 63 of the second heat pipes 60 can be better dissipated by the second heat dissipation structure 02. The addition of the second heat dissipation structure 02 can increase the heat dissipation area at the condensation ends 63 of the second heat pipes 60, thereby reducing the thermal resistance of the overall heat sink. This allows the condensation ends 63 of the second heat pipes 60 connected to the first heat dissipation structure to dissipate the heat more efficiently, which in turn helps improve the heat dissipation efficiency. At the same time, the second air passage can guide cool air to flow in the second preset direction, thereby preventing the cool air from dispersing in all directions, prolonging the contact time between the cool air and the second heat dissipation structure 02, and ultimately further helping to improve the heat dissipation effect.

In the embodiment of the present application, the second heat dissipation structure 02 may be of various structures. For example, the second heat dissipation structure 02 may be a second air-guiding heat dissipation pipe, and the condensation ends 63 of the second heat pipes 60 may extend into the second air-guiding heat dissipation pipe. In this case, a pipe cavity of the second heat-guiding heat dissipation pipe may be considered as the second air passage.

Certainly, the second heat dissipation structure 02 may also be of other structures. In an exemplary embodiment, the second heat dissipation structure 02 may include a second heat dissipation fin 70 and a second enclosing plate 80. The second enclosing plate 80 is disposed around the second heat dissipation fin 70, thereby enclosing the second air passage together with the second heat dissipation fin 70. There may be one or more second heat dissipation fins 70. The embodiment of the present application does not limit the number of the second heat dissipation fins 70. In a case where there is one second heat dissipation fin 70, the second enclosing plate 80 encloses the second heat dissipation fin 70, thereby enclosing the second air passage together with the second heat dissipation fin 70. In a case where there are the plurality of second heat dissipation fins 70, the plurality of second heat dissipation fins 70 are distributed in a stacked manner, and the two adjacent second heat dissipation fins 70 are distributed at intervals, so as to form a second heat dissipation gap. The second enclosing plate 80 encloses a circumferential side of a whole formed by stacking the plurality of second heat dissipation fins 70, so that the second heat dissipation gap between the two adjacent second heat dissipation fins 70 is enclosed to form the second air passage.

In the embodiment of the present application, the second heat dissipation structure 02 is at least formed by the second heat dissipation fins 70. The second heat dissipation structure 02 may include the second heat dissipation fins 70 and further include heat dissipation protrusions disposed on the surfaces of the second heat dissipation fins 70. The heat dissipation protrusions may be strip-shaped protrusions or pin-shaped protrusions, which is not limited in the embodiment of the present application. Certainly, considering that the second heat dissipation fins 70 may be stacked in a case where there are the plurality of second heat dissipation fins 70, in this case, the second heat dissipation structure 02 may further include a connector (e.g., a threaded connector) that connects the plurality of second heat dissipation fins 70.

In one implementation, in a case where there are the plurality of second heat dissipation fins 70, to improve a convective heat dissipation effect, in an exemplary embodiment, the plurality of second heat dissipation fins 70 are distributed at intervals. A second air passage gap may be formed between the two adjacent second heat dissipation fins 70, through which air can penetrate in a convection manner, thereby improving the heat dissipation effect.

Referring again to FIG. 1, the heat sink disclosed in the embodiment of the present application may further include a second enclosing plate 80. The second enclosing plate 80 encloses the circumferential side of the second heat dissipation structure 02, so that a second air passage penetrating therethrough in a second preset direction is formed between the two adjacent second heat dissipation fins 70 in the second heat dissipation structure 02. As described above, the second air passage gap is formed between the two adjacent second heat dissipation fins 70. The disposing of the second enclosing plate 80 can make the second air passage gap to form the second air passage. The second air passage, being a structure with two ends open formed by the second heat dissipation fins 70 and the second enclosing plate 80, can make air to flow from one end of the second air passage to the other end, thereby enabling continuous and good heat exchange with the second heat dissipation fins 70. In essence, in this structure, the second enclosing plate 80 can enclose part of an edge of the second air passage gap, thereby preventing the problem of insufficient heat exchange caused by air dispersing in all directions, which indirectly enhances the heat dissipation capability of the heat sink.

Similarly, the second enclosing plate 80 is connected to the second heat dissipation structure 02, thereby further enhancing the strength of the second heat dissipation structure 02, which in turn helps improve the local strength of the heat sink. Thus, it can be seen that the second enclosing plate 80 can achieve an effect of dual purposes with a single component.

In the embodiment of the present application, the second preset direction and the first preset direction may be the same or different. The second preset direction and the first preset direction may be parallel to the heat dissipation surface 12 or not, which is not limited in the embodiment of the present application. As shown in FIG. 1, in one embodiment, the second preset direction may be consistent with the first preset direction, and both are parallel to the heat dissipation surface 12.

To improve the heat dissipation effect of the condensation ends 23 of the first heat pipes 20, an entrance or an exit of the second air passage may face the condensation ends 23 of the first heat pipes 20 or faces other parts of the first heat pipes 20 other than the evaporation ends 22 thereof. In this case, the air guided by the second air passage will blow directly toward or flow across the condensation ends 23 of the first heat pipes 20 or other parts except the evaporation ends 22, thereby accelerating convective heat dissipation at these locations. This can further enhance the heat dissipation capability of the heat sink. Certainly, the through-directions of the first air passage and the second air passage may also be other directions. The embodiment of the present application does not limit the through-directions of the first air passage and the second air passage.

In the embodiment of the present application, the types of the first phase-change medium and the second phase-change medium may be the same or different. In one implementation, the first phase-change medium and the second phase-change medium may be water or a refrigerant. The embodiment of the present application does not limit the types of the first phase-change medium and the second phase-change medium.

In the embodiment of the present application, the heat dissipation base 10 may be of various structures. For example, the heat dissipation base 10 may be a vapor chamber. Certainly, the heat dissipation base may also be of other plate-like structures. Two opposite plate surfaces of the heat dissipation base 10 may both be heat dissipation surfaces 12, and each of the heat dissipation surfaces 12 may be connected with the first heat pipes 20. In this case, the heat absorbed by the heat dissipation base 10 from the object subjected to heat dissipation is transmitted to distant locations through the two opposite heat dissipation surfaces 12 via the respective first heat pipes 20 connected thereto. This can undoubtedly better share the heat flux density, thereby improving the heat dissipation capability of the heat sink.

The first heat pipes 20 and the second heat pipes 60 may be metal pipes with good heat dissipation performance, such as copper pipes, and aluminum pipes. The heat dissipation base 10 may be a cavity structure formed by a metal component. The material of the heat dissipation base 10 may be copper, aluminum, iron, etc. The embodiment of the present application does not limit the materials of the first heat pipes 20, the second heat pipes 60, and the heat dissipation base 10.

The heat sink disclosed in the embodiment of the present application may be applied to heat dissipation scenarios for high-power, high-heat-flux-density chips, and may also be applied to heat dissipation scenarios for large servers, which is not limited to heat dissipation scenarios such as communication products, automobiles, and consumer electronic products.

Based on the heat sink disclosed in the embodiment of the present application, an embodiment of the present application further discloses an electronic device. The disclosed electronic device includes the heat sink described in the above embodiment. The electronic device disclosed in the embodiment of the present application may be a large server, a power distribution box, or other heat-generating devices. The embodiment of the present application does not limit the type of the electronic device.

The above embodiments of the present application focus on describing the differences between various embodiments. As long as they are not contradictory, the different optimization features of the various embodiments can be combined to form more preferred embodiments, which will not be repeated here for the sake of brevity.

The embodiments of the present application have been described above with reference to the accompanying drawings. However, the present application is not limited to the above specific implementations, and the above specific implementations are merely exemplary and not limitative. Those of ordinary skill in the art may make various variations under the teaching of the present application without departing from the spirit of the present application and the protection scope of the claims, and such variations shall all fall within the protection scope of the present application.

## Claims

1. A heat sink, comprising a heat dissipation base (10) and a first heat pipe (20), wherein the heat dissipation base (10) is provided with an evaporation cavity (11), a first phase-change medium is disposed in the evaporation cavity (11), two ends of the first heat pipe (20) are both closed ends, a second phase-change medium is disposed in a pipe cavity (21) of the first heat pipe (20), an evaporation end (22) of the first heat pipe (20) is connected to a heat dissipation surface (12) of the heat dissipation base (10) and extends in a direction away from the heat dissipation base (10), and the pipe cavity (21) of the first heat pipe (20) is isolated from the evaporation cavity (11).

2. The heat sink according to claim 1, wherein the evaporation end (22) of the first heat pipe (20) is a flattened structure end, and the flattened structure end is connected to the heat dissipation surface (12) in a manner of surface-to-surface attachment.

3. The heat sink according to claim 2, wherein the heat dissipation base (10) is a vapor chamber, the heat dissipation surface (12) is a planar surface, and the evaporation end (22) of the first heat pipe (20) is a flat structure end.

4. The heat sink according to claim 1, further comprising a first heat dissipation structure (01), wherein a condensation end (23) of the first heat pipe (20) is connected in the first heat dissipation structure (01), and the first heat dissipation structure (01) is provided with a first air passage penetrating therethrough in a first preset direction.

5. The heat sink according to claim 4, wherein a plurality of first heat pipes (20) are provided, the evaporation ends (22) of the plurality of first heat pipes (20) are connected to the heat dissipation surface (12) at intervals, any two of the first heat pipes (20) are distributed at intervals, the plurality of first heat pipes (20) are distributed in at least two groups, the first heat dissipation structure (01) comprises a plurality of sub-heat-dissipation structures (011), condensation ends (23) of each group of first heat pipes (20) are connected in the corresponding sub-heat-dissipation structure (011), and each of the sub-heat-dissipation structures (011) is provided with the first air passage penetrating therethrough in the first preset direction.

6. The heat sink according to claim 5, wherein each of the sub-heat-dissipation structures (011) comprises a plurality of first heat dissipation fins (30) and a first enclosing plate (40), the plurality of first heat dissipation fins (30) are distributed in a stacked manner, and the first enclosing plate (40) encloses a circumferential side of a whole formed by stacking the plurality of first heat dissipation fins (30), so that a first heat dissipation gap between the two adjacent first heat dissipation fins (30) is enclosed to form the first air passage.

7. The heat sink according to claim 4, further comprising a connection base plate (50), wherein the connection base plate (50) is fixedly connected to the heat dissipation base (10), and the first heat dissipation structure (01) is supported on the connection base plate (50).

8. The heat sink according to claim 1, wherein a condensation end (23) of the first heat pipe (20) is higher than the evaporation end (22) of the first heat pipe (20).

9. The heat sink according to claim 1, wherein the second phase-change medium is water, and a first capillary structure (24) is disposed in the first heat pipe (20); or, a freezing point of the second phase-change medium is lower than an ice point.

10. The heat sink according to claim 1, further comprising a second heat pipe (60), wherein an evaporation end (61) of the second heat pipe (60) is an open end and makes a pipe cavity (62) of the second heat pipe (60) communicate with the evaporation cavity (11), a condensation end (63) of the second heat pipe (60) extends in a direction away from the heat dissipation surface (12), and the second heat pipe (60) is located within a space enclosed by an edge of the heat dissipation surface (12).

11. The heat sink according to claim 10, wherein the second heat pipe (60) is perpendicular to the heat dissipation surface (12).

12. The heat sink according to claim 10, wherein a plurality of second heat pipes (60) are provided and distributed on the heat dissipation surface (12) in a preset manner.

13. The heat sink according to claim 10, wherein a second capillary structure (64) is disposed in the second heat pipe (60), a third capillary structure (13) is disposed in the evaporation cavity (11), and the second capillary structure (64) is connected to the third capillary structure (13) to form a liquid guiding structure.

14. The heat sink according to claim 10, further comprising a second heat dissipation structure (02), wherein a condensation end (63) of the second heat pipe (60) is connected in the second heat dissipation structure (02), and the second heat dissipation structure (02) is provided with a second air passage penetrating therethrough in a second preset direction.

15. The heat sink according to claim 14, wherein the second heat dissipation structure (02) comprises a plurality of second heat dissipation fins (70) and a second enclosing plate (80), the plurality of second heat dissipation fins (70) are distributed in a stacked manner, and the second enclosing plate (80) encloses a circumferential side of a whole formed by stacking the plurality of second heat dissipation fins (70), so that a second heat dissipation gap between the two adjacent second heat dissipation fins (70) is enclosed to form the second air passage.

16. The heat sink according to claim 14, wherein an entrance or an exit of the second air passage faces the condensation end (23) of the first heat pipe (20) or faces other parts of the first heat pipe (20) other than the evaporation end (22) thereof.

17. The heat sink according to claim 1, wherein the heat dissipation base (10) is a vapor chamber, two opposite plate surfaces of the vapor chamber are both the heat dissipation surfaces (12), and each of the heat dissipation surfaces (12) is connected with the first heat pipes (20).

18. The heat sink according to any one of claims 1 to 17, wherein the condensation ends (23) of the first heat pipes (20) extend beyond edges of the heat dissipation surfaces (12).

19. An electronic device, comprising the heat sink according to any one of claims 1 to 18.
